# EUROPÄISCHE PATENTANMELDUNG

(11) **EP 0 555 804 A1**
(43) Veröffentlichungstag der Anmeldung: **18.08.1993**
(21) Anmeldenummer: 93101961.6
(22) Anmeldetag: 08.02.1993
(51) Int. Cl.: H03B 5/36, H03L 7/099

(54) **Schaltungsanordnung zum Regeln der Frequenz der von einem Quarzoszillator abgegebenen Oszillatortaktsignale**

(30) Priorität: 14.02.1992 DE 9201910 U
(71) Anmelder: SIEMENS AKTIENGESELLSCHAFT, D-80333 München (DE)
(72) Erfinder: Gieck, Reiner, Dipl.-Ing., W-8034 Germering (DE); Högen, Harald, Dipl.-Ing., A-1100 Wien (AT)

(57) **Zusammenfassung**

Die Schaltungsanordnung bildet einen PLL-Kreis mit einem Referenztaktsignale und von dem Quarzoszillator her abgegebene Oszillatortaktsignale vergleichenden Phasenkomparator (PH), dessen Vergleichssignale einer Phasenregeleinrichtung (PR) zugeführt sind. Die aus diesen Vergleichssignalen gewonnenen digitalen Regelsignale sind dem spannungsgesteuerten Quarzoszillator (VCO) über einen Digital-Analog-Wandler (D/A) zugeführt. Dabei ist vorgesehen, daß dem Quarzoszillator (VCO) wenigstens ein Verstärkerelement (INV1) zugehörig ist, welches als frequenzbestimmenden Kreis eine als PI-Glied ausgebildete Rückkoppelanordnung aufweist, in deren Längszweig ein Schwingquarz (QU) angeordnet ist. In den Querzweigen dieser Rückkoppelanordnung ist dagegen jeweils wenigstens eine Kapazitätsdiode (KD1 bzw. KD2) vorgesehen. Die Kapazitätsdioden sind dabei mit den Regelsignalen entsprechenden, gegebenenfalls voneinander abweichenden Diodenspannungen beaufschlagt.

## Beschreibung

Die Erfindung betrifft eine Schaltungsanordnung zum Regeln der Frequenz der von einem spannungsgesteuerten Quarzoszillator abgegebenen Oszillatortaktsignale, mit einem die von dem Quarzoszillator abgegebenen, mit Hilfe eines Frequenzteilers in der Frequenz untersetzten Oszillatortaktsignale und Referenztaktsignale miteinander vergleichenden Phasenkomparator, mit einer nach Maßgabe von am Ausgang des Phasenkomparators auftretenden Vergleichssignalen digitale Regelsignale bereitstellenden Phasenregeleinrichtung und mit einem Digital-Analog-Wandler, welcher mit den digitalen Regelsignalen beaufschlagt ist und diesen entsprechende analoge Regelspannungen an den Quarzoszillator abgibt, welcher in seinem frequenzbestimmenden Kreis wenigstens eine mit den analogen Regelspannungen entsprechenden Diodenspannungen beaufschlagte Kapazitätsdiode aufweist.

Eine derartige Schaltungsanordnung ist bereits bekannt (EP 0 142 826 B1). Bei dieser bekannten Schaltungsanordnung ist für eine Frequenzeinstellung lediglich eine einzige spannungsabhängige Kapazitätsdiode in einem frequenzbestimmenden Kreis eines Quarzoszillators vorgesehen. Um dabei einen möglichst großen Ziehbereich für die Frequenz der von diesem Quarzoszillator abgegebenen Oszillatortaktsignale zu erreichen, ist es erforderlich, für die Ansteuerung der Kapazitätsdiode einen großen Diodenspannungshub vorzusehen. Dies setzt wiederum voraus, daß durch die von dem Digital-Analog-Wandler bereitgestellten analogen Regelspannungen ein entsprechend großer Spannungshub realisierbar ist. Dafür ist ein für allgemeine Anwendungsfälle zuweilen unerwünschter relativ hoher schaltungstechnischer Aufwand erforderlich.

Darüber hinaus ist es bereits bekannt, "Unterrichtsblätter der Deutschen Bundespost", Jahrgang 35, 1982, Nr. 9, Seiten 395 und 396) in einem sogenannten Pierce-Oszillator eine als Pi-Glied ausgebildete Rückkopplungsanordnung zu benutzen, in deren Längszweig eine aus einem Schwingquarz und einem Lastkondensator bestehende Reihenschaltung und in deren Querzweigen jeweils ein Kondensator vorgesehen ist. Diese beiden Kondensatoren bilden einen kapazitiven Spannungsteiler. Der genannte Lastkondensator wird dabei in dieser Schaltungsanordnung zum Ziehen der Frequenz der von dem Oszillator abgegebenen Signale benutzt.

Es ist nun Aufgabe der vorliegenden Erfindung, einen Weg zu zeigen, wie bei einer Schaltungsanordnung der eingangs genannten Art der Quarzoszillator ausgebildet werden kann, um auch bei einem relativ geringen Hub der analogen Regelspannungen einen ausreichend großen Ziehbereich für den Quarzoszillator zu erreichen.

Gelöst wird diese Aufgabe durch die im Patentanspruch 1 angegebenen schaltungstechnischen Merkmale.

Die Erfindung bringt dabei den Vorteil mit sich, daß durch die Verwendung wenigstens zweier Kapazitätsdioden mit einem insgesamt geringen schaltungstechnischen Aufwand bei einem niedrigen Spannungshub der analogen Regelspannungen eine große Kapazitätsänderung innerhalb des frequenzbestimmenden Kreises des Quarzoszillators und damit ein großer Ziehbereich für diesen Quarzoszillator erreicht ist. Durch diesen niedrigen Spannungshub ist es beispielsweise möglich, innerhalb der genannten Schaltungsanordnung mit einer einzigen Versorgungsspannung von beispielsweise + 5 Volt auszukommen, wie sie üblicherweise für digitale Schaltkreise benutzt ist.

Vorteilhafte Ausgestaltungen der Erfindung ergeben sich aus den Unteransprüchen.

Im folgenden wird nun die Erfindung anhand von Zeichnungen beispielsweise näher beschrieben.
Figur 1 zeigt ein Blockschaltbild einer Oszillatoranordnung, bei der die Erfindung angewandt ist, und
Figur 2 zeigt einen möglichen Aufbau eines in Figur 1 lediglich schematisch dargestellten Quarzoszillators.

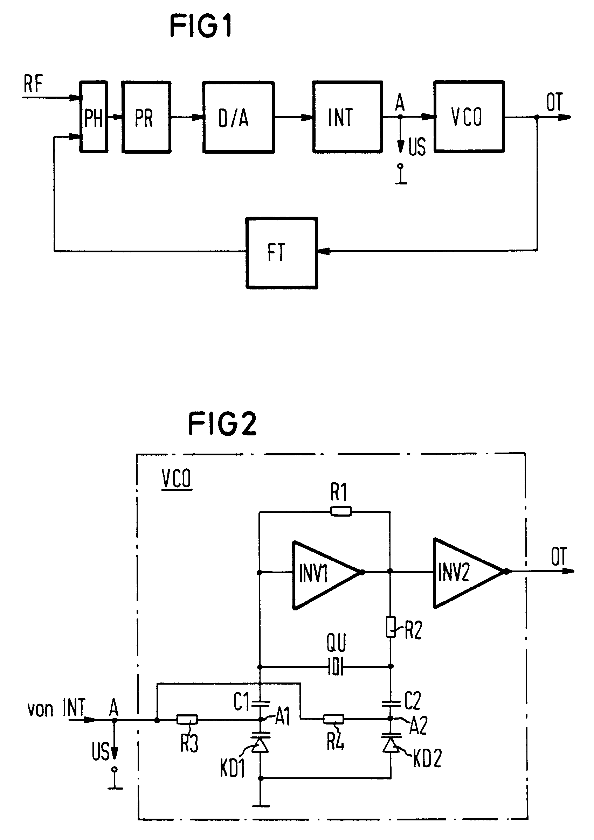

In Figur 1 ist eine als PLL-Kreis ausgebildete Oszillatoranordnung dargestellt, die an einem ersten Eingang eines Phasenkomparators PH Referenztaktsignale RF zugeführt erhält. An einem weiteren Eingang ist dieser Phasenkomparator mit Vergleichstaktsignalen für einen Phasenvergleich beaufschlagt, die durch Frequenzteilung mit Hilfe eines Frequenzteilers FT aus am Ausgang eines spannungsgesteuerten Quarzoszillators VCO auftretenden Oszillatortaktsignalen OT gewonnen werden. Die bei diesem Vergleich ermittelte Phasendifferenz wird in dem Phasenkomparator digitalisiert und als binäre Zahlengröße an eine Phasenregeleinrichtung PR übergeben. Diese Phasenregeleinrichtung ermittelt aus den ihr zugeführten binären Zahlengrößen jeweils ein digitales Regelsignal, welches einem Digital-Analog-Wandler D/A zugeführt ist. Dieser setzt die ihm nacheinander zugeführten digitalen Regelsignale in analoge Signale um, die dem genannten spannungsgesteuerten Quarzoszillator VCO an einem mit A bezeichneten Übergabepunkt als Regelspannungen US zugeführt sind. Ausgangsseitig steht dieser spannungsgesteuerte Quarzoszillator mit dem zuvor genannten Frequenzteiler FT in Verbindung. Bei dem hier beschriebenen Ausführungsbeispiel ist im übrigen zwischen dem Digital-Analog-Wandler D/A und dem spannungsgesteuerten Quarzoszillator VCO ein Integrator INT eingefügt. Das Vorsehen eines solchen Integrators, der beispielsweise aus einem entsprechend beschalteten Operationsverstärker gebildet sein kann, bringt dabei den Vorteil eines stetigen Abgleiches der Frequenz der von dem Quarzoszillator VCO abgegebenen Oszillatortaktsignale mit sich.

Die Wirkungsweisen der zuvor genannten Schaltungselemente Phasenkomparator PH, Phasenregeleinrichtung PR und Digital-Analog-Wandler D/A sind bereits hinlänglich bekannt, so daß im folgenden darauf nicht näher eingegangen wird. Es sei hier lediglich darauf hingewiesen, daß diese Schaltungselemente beispielsweise Bestandteil einer Mikroprozessoranordnung sein können, wie es in der eingangs zitierten Druckschrift (EP 0 142 826 B1) angegeben ist.

In Figur 2 ist ein möglicher Aufbau des zuvor genannten Quarzoszillators VCO dargestellt. Danach weist dieser als Verstärkerelement einen beispielsweise in HCMOS-Technik realisierten Inverter INV1 auf, der extern mit einem hochohmigen Rückkoppelwiderstand R1 beschaltet ist. Weiterhin ist mit dem Ausgang dieses Inverters ein gegenüber dem Rückkoppelwiderstand R1 niederohmiger Widerstand R2 verbunden, über den eine frequenzbestimmende Rückkoppelanordnung zwischen diesen Ausgang und den Eingang des Inverters geschaltet ist. Diese Widerstände können dabei beispielsweise im MOhm- bzw. kOhm-Bereich liegen.

Die gerade erwähnte Rückkoppelanordnung ist als Pi-Glied ausgebildet, in dessen Längszweig sich ein Schwingquarz QU befindet. In den beiden Querzweigen des Pi-Gliedes ist dagegen jeweils eine mit ihrer Kathode über einen Kondensator mit dem jeweiligen Anschluß des Schwingquarzes und mit ihrer Anode an Masse liegende Kapazitätsdiode angeordnet. Die jeweilige Kapazitätsdiode und der mit dieser verbundene Kondensator sind in den beiden Querzweigen mit KD1 und C1 bzw. KD2 und C2 bezeichnet.

An dem mit A1 bezeichneten Verbindungspunkt zwischen der Kathode der Kapazitätsdiode KD1 und dem Kondensator C1 ist ein Widerstand R3 angeschlossen. In entsprechender Weise ist mit dem mit A2 bezeichneten Verbindungspunkt der Kathode der Kapazitätsdiode KD2 und des Kondensators C2 ein Widerstand R4 verburden. Die verbleibenden Anschlüsse dieser Widerstände sind gemeinsam an den in Figur 1 dargestellten Anschluß A des Quarzoszillators VCO herangeführt, um die beiden Kapazitätsdioden mit den an diesem Anschluß A auftretenden analogen Regelspannungen entsprechenden Diodenspannungen zu versorgen. Die zuvor genannten Kondensatoren C1 und C2 dienen dabei zur gleichstrommäßigen Entkopplung der Kapazitätsdioden von den übrigen zuvor erwähnten Schaltungselementen des Inverters INV1. Die Kapazitäten dieser Kondensatoren sind entsprechend dem Ziel einer möglichst großen Frequenzvariation wesentlich größer als die maximal durch die Kapazitätsdioden realisierbaren Kapazitäten gewählt.

Die Dimensionierung der genannten Widerstände R3 und R4 hängt von den Kennlinien und damit von den zu realisierenden Variationsbereichen der Kapazitäten der Kapazitätsdioden KD1 und KD2 ab. Dabei können den Kapazitätsdioden über diese Widerstände gegebenenfalls unterschiedliche Diodenspannungen zugeführt sein. Dies ist beispielsweise dann zweckmäßig, wenn für die Realisierung eines bestimmten Frequenzziehbereiches des Quarzoszillators VCO für die beiden Kapazitätsdioden hinsichtlich der Kapazitäten unterschiedliche Variationsbereiche gewünscht sind bzw. wenn Kapazitätsdioden mit unterschiedlichen Kennlinien verwendet werden. Darüber hinaus kann der in Figur 2 dargestellte Quarzoszillator auch derart modifiziert sein, daß für die Erzielung eines bestimmten Frequenzziehbereiches bei einem vorgegebenen Regelspannungshub in den beiden Querzweigen jeweils anstelle einer einzigen Kapazitätsdiode beispielsweise eine Mehrzahl von Kapazitätsdioden parallel geschaltet ist, wobei jede dieser über einen gesonderten Widerstand eine entsprechende Diodenspannung zugeführt erhält.

Bezüglich des in Figur 2 dargestellten Ausführungsbeispiels für einen Quarzoszillator sei noch darauf hingewiesen, daß in diesem dem genannten Inverter INV1 ein weiterer, den Ausgang des Quarzoszillators bildender Inverter INV2 nachgeschaltet ist. Dieser Inverter INV2 dient dabei lediglich für eine Entkopplung des Quarzoszillators von den diesen nachfolgenden Schaltungen und bewirkt gleichzeitig eine Phasendrehung der von dem Quarzoszillator abgegebenen Oszillatortaktsignale OT um 180^{o}.

Abschließend sei noch darauf hingewiesen, daß die vorliegende Erfindung lediglich als Beispiel anhand eines Quarzoszillators mit einem Inverter als Verstärkerelement beschrieben worden ist. Anstelle eines solchen Inverters kann jedoch auch ein anderweitiges Verstärkerelement beispielsweise in Form eines handelsüblichen Operationsverstärkers benutzt sein.

## Patentansprüche

1. Schaltungsanordnung zum Regeln der Frequenz der von einem spannungsgesteuerten Quarzoszillator (VCO) abgegebenen Oszillatortaktsignale, mit einem die von dem Quarzoszillator abgegebenen, mit Hilfe eines Frequenzteilers (FT) in der Frequenz untersetzten Oszillatortaktsignale und Referenztaktsignale miteinander vergleichenden Phasenkomparator (PH), mit einer nach Maßgabe von am Ausgang des Phasenkomparators auftretenden Vergleichssignalen digitale Regelsignale bereitstellenden Phasenregeleinrichtung (PR) und mit einem Digital-Analog-Wandler (D/A), welcher mit den digitalen Regelsignalen beaufschlagt ist und diesen entsprechende analoge Regelspannungen an den Quarzoszillator (VCO) abgibt, welcher in seinem frequenzbestimmenden Kreis wenigstens eine mit den analogen Regelspannungen entsprechenden Diodenspannungen beaufschlagte Kapazitätsdiode (KD1 bzw. KD2) aufweist
**dadurch gekennzeichnet,**
daß dem Quarzoszillator (VCO) wenigstens ein Verstärkerelement (INV1) zugehörig ist, welches als frequenzbestimmenden Kreis eine als Pi-Glied ausgebildete Rückkoppelanordnung aufweist, in deren Längszweig ein Schwingquarz (QU) und in deren Querzweigen jeweils wenigstens eine Kapazitätsdiode (KD1 bzw. KD2) angeordnet sind,
und daß die Kapazitätsdioden mit den analogen Regelspannnungen entsprechenden, gegebenenfalls voneinander abweichenden Diodenspannungen beaufschlagt sind.

2. Schaltungsanordnung nach Anspruch 1,
**dadurch gekennzeichnet,**
daß die Kapazitätsdioden (KD1 und KD2) unterschiedliche Dioden-Kennlinien aufweisen.

3. Schaltungsanordnung nach Anspruch 1 oder 2,
**dadurch gekennzeichnet,**
daß in den Querzweigen der Rückkopplungsanordnung jeweils eine Mehrzahl von Kapazitätsdioden parallel geschaltet ist.

4. Schaltungsanordnung nach einem der Ansprüche 1 bis 3,
**dadurch gekennzeichnet,**
daß als Verstärkerelement (INV1) ein Inverter in TTL-Technik verwendet ist.

5. Schaltungsanordnung nach einem der Ansprüche 1 bis 4,
**dadurch gekennzeichnet,**
daß zwischen dem Digital-Analog-Wandler (D/A) und dem Quarzoszillator (VCO) ein Integrator (INT) geschaltet ist.
